# FASCICULE DE BREVET EUROPEEN

(11) **EP 3 329 511 B1**
(45) Date de publication et mention de la délivrance du brevet: **03.07.2019**
(21) Numéro de dépôt: 16751221.9
(22) Date de dépôt: 26.07.2016
(51) Int. Cl.: H01L 21/60

(54) **PROCEDE DE COLLAGE DIRECT AVEC AUTO-ALIGNEMENT PAR ULTRASONS**
VERFAHREN ZUM DIREKTEN BONDEN MIT SELBSTAUSRICHTUNG UNTER VERWENDUNG VON ULTRASCHALL
METHOD FOR DIRECT BONDING WITH SELF-ALIGNMENT USING ULTRASOUND

(30) Priorité: 31.07.2015 FR 1557402
(43) Date de publication de la demande: 06.06.2018
(73) Titulaire: Commissariat à l'énergie atomique et aux énergies alternatives, 75015 Paris (FR)
(72) Inventeur: FOURNEL, Frank, 38190 Villard-Bonnot (FR); BAILLIN, Xavier, 38920 Crolles (FR); CHERAMY,Séverine, 38640 Claix (FR); LEDUC, Patrick, 38000 Grenoble (FR); SANCHEZ, Loic, 38500 Voiron (FR)
(74) Mandataire: Brevalex
(86) Numéro de dépôt international: PCT/EP2016/067827
(87) Numéro de publication internationale: WO 2017/021231

(56) Documents cités:
- JP-A- 2003 209 397
- JP-A- 2005 014 141
- JP-A- 2005 174 979
- JP-A- 2005 317 694
- US-B2- 8 303 778
- SANCHEZ L ET AL: "Chip to wafer direct bonding technologies for high density 3D integration", ELECTRONIC COMPONENTS AND TECHNOLOGY CONFERENCE (ECTC), 2012 IEEE 62ND, IEEE, 29 mai 2012 (2012-05-29), pages 1960-1964, XP032210861, DOI: 10.1109/ECTC.2012.6249108 ISBN: 978-1-4673-1966-9
- JIAN LU ET AL: "High-Efficient Chip to Wafer Self-Alignment and Bonding Applicable to MEMS-IC Flexible Integration", IEEE SENSORS JOURNAL, IEEE SERVICE CENTER, NEW YORK, NY, US, vol. 13, no. 2, 1 février 2013 (2013-02-01), pages 651-656, XP011487777, ISSN: 1530-437X, DOI: 10.1109/JSEN.2012.2225422
- BOHRINGER K-F ET AL: "Parallel microassembly with electrostatic force fields", PROCEEDINGS / 1998 IEEE INTERNATIONAL CONFERENCE ON ROBOTICS AND AUTOMATION, MAY 16 - 20, 1998, KATHOLIEKE UNIVERSITEIT LEUVEN, LEUVEN, BELGIUM, IEEE, NEW YORK, NY, USA, vol. 2, 16 mai 1998 (1998-05-16), pages 1204-1211, XP010281184, DOI: 10.1109/ROBOT.1998.677259 ISBN: 978-0-7803-4300-9

## Description

### DOMAINE TECHNIQUE ET ART ANTÉRIEUR

L'invention concerne un procédé de collage direct auto-aligné d'au moins une puce électronique sur un substrat ou sur au moins une autre puce électronique. On entend par puce électronique (également appelée *« Die »* ou « *Chip* » en anglais), une partie d'un substrat ayant ou non déjà subi des étapes technologiques de la microélectronique formant par exemple des composants électroniques dans cette partie du substrat. Une telle puce électronique peut correspondre à un circuit intégré. On entend par substrat, une plaque ou une plaquette (également appelé « wafer » en anglais), par exemple en semi-conducteur (en général en silicium), ayant ou non déjà subie des étapes technologiques de la microélectronique formant par exemple des composants électroniques dans le substrat. Ces étapes technologiques de la microélectronique sont par exemple des étapes de lithographie, de gravure et de dépôt.

Le collage direct, également appelé « collage moléculaire », ou encore *« wafer bonding »* ou *« direct bonding »* en anglais, est une technique d'assemblage permettant de solidariser deux surfaces via une mise en contact direct de ces deux surfaces sans faire appel à un matériau de collage (colle, cire, etc.). Dans ce type de collage, l'adhérence est obtenue grâce au fait que les surfaces à coller sont suffisamment lisses (typiquement avec une rugosité de l'ordre de 0,5 nm RMS (Roughness Mean Square)), exemptes de particules ou de contaminations, et rapprochées suffisamment l'une de l'autre pour permettre d'initier un contact intime entre les surfaces. Dans ce cas, les forces attractives entre les deux surfaces sont assez élevées pour provoquer une adhérence moléculaire des deux surfaces l'une avec l'autre. Le collage moléculaire est induit par l'ensemble des forces attractives d'interaction électronique entre les atomes ou molécules des deux surfaces à coller (forces de Van der Waals). Des traitements thermiques peuvent être réalisés pendant ou après le collage pour augmenter l'énergie de collage entre les surfaces assemblées.

Un tel collage direct peut correspondre à un collage dit *« hydrophobe »,* par exemple entre deux substrats de silicium monocristallin. Dans ce cas, avec deux substrats de silicium cristallin, le collage direct forme alors un *« raccord* » cristallin entre les matériaux collés. Le collage direct peut également correspondre à un collage dit *« hydrophile »,* par exemple entre deux substrats de silicium oxydé. Dans un tel collage hydrophile, un film d'eau présent entre les deux substrats permet d'obtenir des interactions par liaisons hydrogène plus fortes que les forces de Van der Waals.

Pour réaliser un collage direct auto-aligné hydrophile d'une puce électronique sur un substrat ou sur une autre puce électronique, il est possible de faire appel à différentes techniques d'auto-alignement utilisant un fluide comme média d'auto-alignement. Par exemple, dans le document « Multichip Self-Assembly Technology for Advanced Die-to-Wafer 3-D Integration to Prcisely Align Known Good Dies in Batch Processing » de T. Fukushima et al., IEEE Transactions on Components, Packaging and Manufacturing Technology, vol. 1, n°12, décembre 2011, pages 1873-1884, il est décrit un moyen d'auto-aligner une puce électronique sur un substrat comportant des zones hydrophiles et hydrophobes via l'utilisation d'une goutte d'eau confinée sur une zone hydrophile correspondant à l'emplacement de la puce. La puce est disposée sur la goutte d'eau qui permet un alignement de la puce vis-à-vis de son emplacement sur le substrat.

L'inconvénient de ces techniques est qu'elles ne permettent pas d'explorer l'ensemble des configurations d'alignement possibles pour choisir ensuite la configuration optimale conférant le meilleur alignement de la puce sur le substrat. Dans le procédé décrit dans le document cité ci-dessus, si la puce est désalignée de quelques dixièmes de degré après un premier positionnement sur le substrat, ce désalignement, qui peut être la conséquence de différentes raisons comme par exemple la présence de forces de capillarité parasites subies par la puce, peut persister jusqu'à la solidarisation complète de la puce sur le substrat.

### EXPOSÉ DE L'INVENTION

Un but de la présente invention est de proposer un procédé de collage direct auto-aligné d'une puce électronique sur un substrat ou sur une autre puce électronique, utilisant un fluide comme média d'auto-alignement et ayant une meilleure efficacité d'auto-alignement que les procédés de collage de l'art antérieur.

Pour cela, l'invention propose un procédé de collage direct selon la revendication 1, c'est-à-dire un procédé d'au moins une première puce électronique sur un substrat ou sur au moins une deuxième puce électronique, comportant au moins les étapes de :
- réalisation, sur chacune d'une face de la première puce électronique et d'une première face du substrat ou de la deuxième puce électronique, d'au moins une première et une deuxième parties ayant une différence d'angle de contact vis-à-vis d'un premier fluide qui est supérieure à environ 70° l'une par rapport à l'autre, telles que les premières parties aient des angles de contact vis-à-vis du premier fluide inférieurs à ceux des deuxièmes parties et aient des formes et des dimensions sensiblement similaires l'une par rapport à l'autre, et telles que, sur chacune de la face de la première puce électronique et de la première face du substrat ou de la deuxième puce électronique, la première partie est délimitée par la deuxième partie ;
- dépôt du premier fluide sur la première partie de la première face du substrat ou de la deuxième puce électronique ;
- dépôt de la première partie de la face de la première puce électronique sur le premier fluide ;
- retrait du premier fluide jusqu'à l'obtention d'une solidarisation de la première partie de la face de la première puce électronique avec la première partie de la première face du substrat ou de la deuxième puce électronique ;
et comportant en outre, pendant au moins une partie du retrait du premier fluide, une émission d'ultrasons dans le premier fluide à travers le substrat ou la deuxième puce électronique, les ultrasons émis ayant une fréquence supérieure ou égale à environ 1 MHz, et dans lequel, pendant une première partie du retrait du premier fluide, la puissance d'émission des ultrasons est telle que des bulles de cavitation sont formées dans le premier fluide, puis, pendant une deuxième partie du retrait du premier fluide, la puissance d'émission des ultrasons est réduite afin de stopper la création des bulles de cavitation tout en exerçant une pression mécanique sur la première puce électronique .

Grâce à l'émission des ultrasons dans le premier fluide pendant la phase de retrait du premier fluide, la première puce électronique est soumise à une perturbation mécanique pendant ce retrait du premier fluide, c'est-à-dire lors de l'auto-alignement de la première puce électronique par rapport à la première partie de la première face du substrat ou de la deuxième puce électronique. Cet auto-alignement est dicté par la minimisation de l'énergie de mouillage vis-à-vis des parties qui ont des angles de contact différents. Les ultrasons traversent le substrat ou la deuxième puce électronique pour se propager ensuite dans le premier fluide servant de média à l'auto-alignement de la première puce électronique. Ces ultrasons peuvent alors, selon la puissance avec laquelle ils sont émis, soit exercer une pression mécanique sur la première puce électronique, soit créerdes bulles de cavitation dans le premier fluide qui exerceront à leur tour une pression mécanique sur la première puce électronique, modifiant la position de la première puce électronique et permettant que les forces d'auto-alignement auxquelles la première puce électronique est soumise reprennent de l'amplitude. En étant exposée aux ultrasons, la première puce électronique va osciller autour de la position d'alignement optimal pour atteindre ensuite, à la fin du retrait du premier fluide, cette position d'alignement optimal.

De manière avantageuse, le premier fluide peut être de l'eau.

Les ultrasons émis ont une fréquence supérieure ou égale à environ 1 MHz. De tels ultrasons sont également appelés « mégasons ». De manière générale, les ultrasons utilisés peuvent avoir une fréquence allant jusqu'à environ 10 MHz.

Les ultrasons peuvent être émis avec une puissance comprise entre environ 0,1 W/cm² et 5 W/cm².

Selon l'invention, pendant une première partie du retrait du premier fluide, la puissance d'émission des ultrasons peut être telle que des bulles de cavitation soient formées dans le premier fluide, puis, pendant une deuxième partie du retrait du premier fluide, la puissance d'émission des ultrasons peut être réduite afin de stopper la création des bulles de cavitation tout en exerçant une pression mécanique sur la première puce électronique. Ainsi, des bulles de cavitation sont créées dans le premier fluide durant la première partie du retrait du premier fluide, assurant ainsi une bonne action mécanique sur la première puce électronique. L'oscillation de la première puce électronique diminue ensuite lors de la deuxième partie du retrait jusqu'à ce que la première puce électronique soit à son optimum d'alignement à la fin du retrait du premier fluide.

Dans ce cas, la puissance d'émission des ultrasons pendant la première partie du retrait du premier fluide peut être supérieure ou égale à environ 1 W/cm², et/ou la puissance d'émission des ultrasons pendant la deuxième partie du retrait du premier fluide peut être réduite jusqu'à une valeur inférieure ou égale à environ 0,2 W/cm².

Les ultrasons peuvent être émis par un émetteur couplé acoustiquement à une deuxième face, opposée à la première face, du substrat ou de la deuxième puce électronique par l'intermédiaire d'un film d'un deuxième fluide. Le deuxième fluide peut être de nature similaire ou non au premier fluide. Une telle configuration assure une bonne transmission des ultrasons jusque dans le premier fluide se trouvant entre la première puce électronique et le substrat ou entre les première et deuxième puces électroniques. L'expression « film de fluide » désigne ici une fine couche de fluide, par exemple d'épaisseur comprise entre environ 10 µm et 10 cm.

De manière avantageuse, le deuxième fluide peut être de l'eau.

La réalisation, sur la face de la première puce électronique et/ou sur la première face du substrat ou de la deuxième puce électronique, des première et deuxième parties peut comporter la mise en oeuvre d'une étape de gravure de la face de la première puce électronique et/ou de la première face du substrat ou de la deuxième puce électronique autour de premières régions destinées à former les premières parties telle que les premières parties soient formées par des faces supérieures des premières régions et que les deuxièmes parties soient formées au moins par des flancs latéraux des premières régions. Cette gravure réalise des marches, ou des zones saillantes, vis-à-vis du reste de la face de la première puce électronique et/ou de la première face du substrat ou de la deuxième puce électronique. Ainsi, sur la face de la première puce électronique et/ou sur la première face du substrat ou de la deuxième puce électronique, la différence d'angle de contact entre les premières et deuxièmes parties est obtenue au moins par ces marches, ou ces différences de niveau, dont au moins les flancs latéraux correspondent à la deuxième partie. Avantageusement, les arrêtes de ces marches, qui délimitent les premières parties vis-à-vis des deuxièmes parties, sont vives, c'est-à-dire sont telles que l'angle formé entre les flancs latéraux et les faces supérieures de ces marches correspond à un angle rentrant inférieur à environ 90°.

Dans ce cas, le procédé peut comporter en outre, après l'étape de gravure, une étape de traitement modifiant la valeur de l'angle de contact des flancs latéraux des premières régions et/ou de l'angle de contact de deuxièmes régions entourant les premières régions, vis-à-vis du premier fluide. Lorsque le premier fluide est de l'eau et que le traitement correspond à un traitement hydrophobe, en entourant ainsi une zone hydrophile (première partie) par une arrête vive et un flanc de gravure hydrophobe (deuxième partie), la zone hydrophile est très bien délimitée, ce qui permet de mieux localiser le premier fluide sur cette zone hydrophile. La présence de l'arrête entre les première et deuxième parties ajoute à la différence d'angle de contact entre les deux parties un angle supplémentaire par exemple de 90°.

Le retrait du premier fluide peut comporter avantageusement une évaporation du premier fluide.

Les étapes du procédé peuvent être mises en oeuvre collectivement pour réaliser le collage direct de plusieurs premières puces électroniques sur le substrat. Ainsi, une pluralité de premières parties à faible angle de contact peuvent être délimitées par une ou plusieurs deuxièmes parties à fort angle de contact sur la première face du substrat, permettant ainsi d'obtenir un auto-alignement, séquentiellement ou avantageusement simultanément, des premières puces électroniques sur le substrat.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :

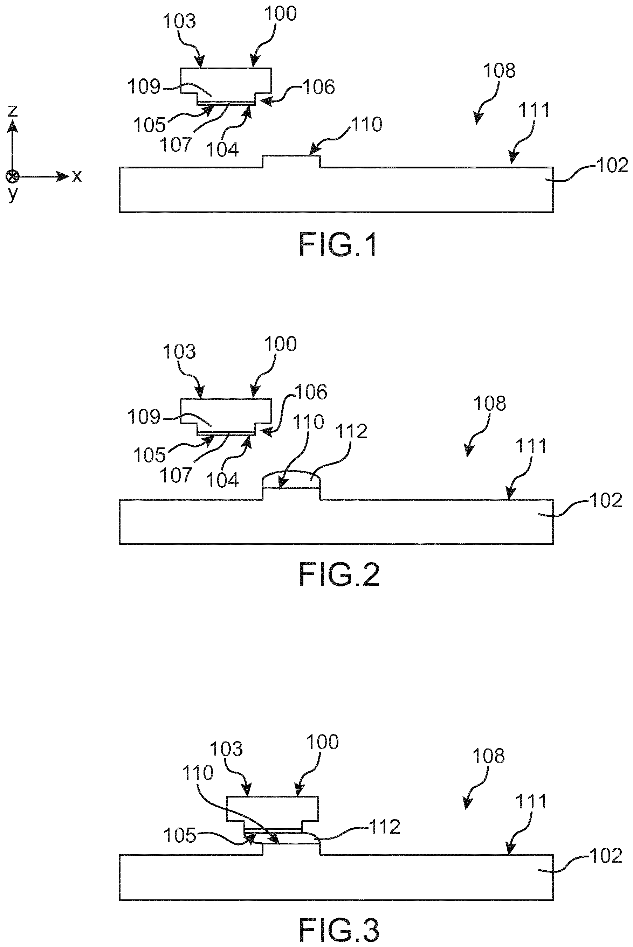

- les figures 1 à 5 représentent les étapes d'un procédé de collage direct, objet de la présente invention, selon un mode de réalisation particulier.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

Un exemple de mise en oeuvre d'un procédé de collage direct d'une puce électronique 100 sur un substrat 102 est décrit en liaison avec les figures 1 à 5.

La puce électronique 100, ici en silicium, est obtenue par sciage d'une plaque, ou substrat, de silicium d'orientation cristalline <001>, de diamètre égal à environ 200 mm et de résistivité comprise entre environ 1 et 14 Ohm/cm avec un dopage de type P. Les dimensions de la puce sont ici égales à environ 1 mm *1 mm (dans un plan parallèle au plan (X,Y) sur la figure 1) et son épaisseur (dimension selon l'axe Z) est égale à environ 725 µm. La puce électronique 100 correspond à une portion de semi-conducteur ayant ou non déjà subie des étapes technologiques de la microélectronique formant par exemple des composants électroniques sur cette puce électronique 100. De tels composants (non représentés sur les figures 1 à 5) peuvent être présents au niveau d'une face arrière 103 et/ou d'une face avant 104 de la puce électronique 100.

La puce électronique 100 comporte, au niveau de sa face avant 104 qui correspond à celle destinée à être solidarisée au substrat 102, une première partie 105 qui correspond à la région de la face avant 104 destinée à être en contact avec le substrat 102. Une deuxième partie 106 de la face avant 104 qui entoure la première partie 105 correspond à une partie gravée de la puce électronique 100 et formant une marche au niveau des bords de la puce électronique 100. La première partie 105 est par exemple formée par une face supérieure d'une couche d'oxyde de silicium 107 disposée sur une partie saillante 109, par exemple en silicium, de la puce électronique 100. La deuxième partie 106 comprend les flancs latéraux de la partie saillante 109 et de la couche 107 ainsi que les autres parties de la face avant 104, également en silicium, qui se trouvent autour de la première partie 105. La différence entre l'angle de contact de la première partie 105 et celui de la deuxième partie 106 est supérieure à environ 70°.

La gravure formant la deuxième partie 106 de la face avant 104 est réalisée avant le découpage de la puce électronique 100, par exemple par photolithographie et gravure HF. Après sa découpe, la puce électronique 100 est nettoyée par brossage avec une solution ammoniaquée (eau déionisée avec 1% d'ammoniaque) pour enlever la contamination particulaire. La puce électronique 100 est ensuite soumise à un traitement plasma oxygène pour enlever la contamination hydrocarbonée encore présente. Ces traitements chimiques permettent de rendre hydrophile la première partie 105 de la face avant 104. L'utilisation d'une solution d'acide fluorhydrique ou d'un plasma hydrogène permet de rendre hydrophobe le matériau qui est révélé par cette gravure, au niveau de la deuxième partie 106 de la face avant 104, tout en laissant la première partie 105 hydrophile.

En variante, il est possible que les zones gravées de la puce électronique 100, localisées en périphérie de la partie saillante 109, soient recouvertes d'oxyde de silicium. Dans ce cas, la deuxième partie 106 est formée uniquement des flancs latéraux de la partie saillante 109 et de la couche 107, et non de l'oxyde de silicium présent autour de la partie saillante 109.

Au niveau de la face avant 104, une marche présentant un surface (face supérieure de la couche 107) ayant un faible angle de contact (première partie 105), par exemple hydrophile, entourée de la deuxième partie 106 ayant un fort angle de contact, par exemple hydrophobe, est ainsi obtenue. Cette configuration est avantageuse car elle permet d'accroître d'environ 90° la différence d'angle de contact entre la surface correspondant à la première partie 105 et celles formées par la deuxième partie 106. L'angle formé entre la face supérieure de la marche et le reste de la face avant 104 peut être différent de 90°, et notamment supérieur ou inférieur à 90°.

Dans une autre configuration, il est possible que les première et deuxième parties 105, 106 se trouvent dans un même plan au niveau de la face avant 104, c'est-à-dire que la face avant 104 ne comporte pas de partie saillante. Les première et deuxième parties 105, 106 sont alors réalisées par des traitements localisés tels qu'une ou plusieurs premières parties 105 hydrophiles soient entourées d'une ou plusieurs deuxièmes parties 106 hydrophobes.

Le substrat 102, ici un substrat de silicium, est aussi préparé pour réaliser le collage direct de la puce électronique 100 sur une face avant 108 du substrat 102. Pour cela, au moins une tranchée est réalisée par photolithographie et gravure dans une partie de l'épaisseur du substrat 102, autour d'une première partie 110 de la face avant 108 sur laquelle la première partie 105 de la face avant 104 de la puce électronique 100 est destinée à être collée, afin d'isoler cette première partie 110 de la face avant 108 du substrat 102 vis-à-vis du reste de la face avant 108 du substrat 102 formant une deuxième partie 111. Sur la figure 1, toute la partie de la face avant 108 du substrat 102 se trouvant autour de la première partie 110 est gravée et forme la deuxième partie 111 de cette face avant 108. Cette première partie 110 a un motif et des dimensions, dans un plan principal du substrat 102 (plan parallèle au plan (X,Y)), similaires à ceux de la première partie 105 de la face avant 104 de la puce électronique 100. Le substrat 102 subit les mêmes traitements chimiques de surface que ceux subis par la puce électronique 100 afin de rendre hydrophile la première partie 110 de la face avant 108 du substrat 102 et de rendre hydrophobe le reste de la surface du substrat 102 révélée en gravant la partie de la face avant 108 se trouvant autour de la première partie 110 et formant la deuxième partie 111 de la face avant 108 du substrat 102.

Dans l'exemple décrit ici, les surfaces des premières parties 105 et 110 ont une rugosité compatible avec la mise en oeuvre d'un collage direct, c'est-à-dire ont une rugosité inférieure ou égale à environ 0,5 nm RMS.

Une goutte d'un fluide 112, ici de l'eau, est ensuite posée sur la surface de la première partie 110 de la face avant 108 du substrat 102 destinée à recevoir la puce électronique 100 (figure 2). Ce dépôt peut se faire individuellement goutte par goutte. Toutefois, lorsque la face avant 108 du substrat 102 comporte plusieurs premières parties 110, le dépôt des gouttes 112 peut être collectif et être obtenu par exemple par la mise en oeuvre d'une pulvérisation ou d'un épandage d'eau sur la face avant 108, l'excédent d'eau présent sur la face avant 108 étant ensuite éliminé. La première partie 105 de la face avant 104 de la puce électronique 100 est posée alors sur la goutte 112 (figure 3). La puce électronique 100 va s'aligner grossièrement pour optimiser sa surface en contact avec le substrat 102 et ainsi presque aligner les deux surfaces des premières parties 105 et 110 destinées à être solidarisées l'une à l'autre.

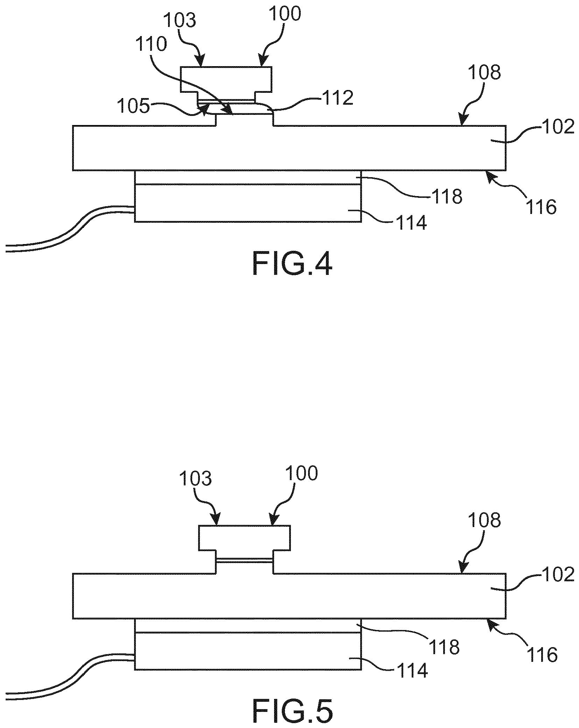

Ensuite, une phase de retrait est mise en oeuvre afin que la goutte 112 s'évapore et que les surfaces des parties 105 et 110 soient solidarisées l'une à l'autre. Au cours de cette phase de retrait, un émetteur d'ultrasons 114 est couplé acoustiquement à une face arrière 116 du substrat 102 et émet à travers cette face arrière 116 des ultrasons par exemple de fréquence égale ou supérieure à environ 1 MHz et de puissance supérieure ou égale à environ 0,2 W/cm². Le couplage acoustique de l'émetteur 114 avec la face arrière 116 du substrat 102 est réalisé par l'intermédiaire d'un film d'un deuxième fluide 118, avantageusement un film d'eau (voir figure 4). Pour obtenir un tel film 118, le deuxième fluide est disposé sur l'émetteur 114, puis le substrat 102 est disposé sur l'émetteur 114. Le film 118 subsiste alors entre l'émetteur 114 et la face arrière 116 du substrat 102.

En variante, il est possible de prévoir, entre la face arrière 116 du substrat 102 et l'émetteur 114, un dispositif étanche, par exemple en forme de cylindre, rempli du deuxième fluide et qui est obturé d'un côté par la face arrière 116 du substrat 102 et de l'autre côté par l'émetteur 114.

Les ondes acoustiques émises par l'émetteur 114 vont traverser le film 118, le substrat 102 et la goutte 112 pour atteindre la puce électronique 100. La puce électronique 100 subit une sollicitation mécanique verticale, c'est-à-dire selon une direction sensiblement perpendiculaire à l'interface de collage souhaitée, via le média formé par la goutte 112 qui se trouve entre la puce électronique 100 et le substrat 102. L'action mécanique des ondes acoustiques va alors faire bouger la puce électronique 100 qui va ainsi osciller autour de la position d'équilibre, ou position d'alignement optimum, qui correspond celle conférant le meilleur alignement des surfaces en regard l'une de l'autre (voir figure 5).

Si la puissance d'émission des ultrasons est supérieure ou égale à environ 1 W/cm², des bulles de cavitation apparaissent dans la goutte 112, renforçant l'action mécanique des ultrasons sur la puce électronique 100. Pendant le retrait de la goutte 112, les ultrasons sont envoyés tout d'abord avec une puissance importante supérieure ou égale à environ 1 W/cm². Au cours du retrait de la goutte 112, cette puissance est graduellement réduite jusqu'à atteindre une valeur inférieure ou égale à environ 0,2 W/cm². Cette réduction progressive de la puissance d'émission des ultrasons permet d'optimiser l'alignement de la puce électronique 100 par rapport à la première partie 110 de la face avant 108 du substrat 102.

L'émission des ultrasons peut être interrompue soit avant le retrait complet de la goutte 112 et donc de la solidarisation de la puce électronique 100 sur le substrat 102, soit une fois que la solidarisation de la puce électronique 100 sur le substrat 102 est achevée.

Le procédé de collage direct précédemment décrit peut s'appliquer au collage de la puce électronique 100 non pas sur le substrat 102 mais sur une deuxième puce électronique. Il est également possible que ce procédé de collage direct soit mis en oeuvre collectivement pour réaliser simultanément un collage direct de plusieurs puces électroniques sur le substrat 102.

En variante, le premier fluide de la goutte 112 et/ou le deuxième fluide du film 118 peuvent être remplacés par un fluide autre que de l'eau, polaire ou apolaire, par exemple du méthanol, de l'acétone, du dimethylsulfonique, de l'acétonitrile, de la pyridine, de l'ammoniaque, de l'éthanol, de l'hexane, du pentane, du benzène, du toluène, du chloroforme, etc.

Le substrat 102 et/ou la puce 100 peuvent être réalisés à partir d'un matériau autre que le silicium. De plus, à la place de l'oxyde de silicium de la couche 107, cette couche peut être formée d'un oxyde de semi-conducteur autre que le silicium, ou encore par exemple d'un nitrure de semi-conducteur, d'alumine, de SiOC, de HfO₂, d'un métal (Ti, Cu, Ni, etc.), ou de carbone.

Après le retrait de la goutte 112, les éléments solidarisés par le collage direct peuvent être soumis à un ou plusieurs traitements thermiques permettant un renforcement des forces d'adhésion, et donc de l'énergie de collage, entre ces éléments. Lorsque des composants électroniques sont présents sur au moins l'un de ces éléments, les températures de ces traitements thermiques peuvent être comprises entre environ 200°C et 400°C. Dans le cas contraire, les températures de traitements thermiques peuvent aller jusqu'à environ 1100°C.

Un tel procédé de collage direct s'applique avantageusement au domaine de la microélectronique 3D pour réaliser un collage de puces électroniques comportant des composants CMOS sur un substrat comportant des composants CMOS, ainsi qu'au domaine de l'optoélectronique pour réaliser un collage de puces électroniques à base de semi-conducteur III/V, comportant par exemple des composants lasers, sur un substrat en silicium comportant des composants CMOS.

## Revendications

1. Procédé de collage direct d'au moins une première puce électronique (100) sur un substrat (102) ou sur au moins une deuxième puce électronique, comportant au moins les étapes de :
- réalisation, sur chacune d'une face (104) de la première puce électronique (100) et d'une première face (108) du substrat (102) ou de la deuxième puce électronique, d'au moins une première et une deuxième parties (105, 110, 106, 111) ayant une différence d'angle de contact vis-à-vis d'un premier fluide (112) qui est supérieure à environ 70° l'une par rapport à l'autre, telles que les premières parties (105, 110) aient des angles de contact vis-à-vis du premier fluide (112) inférieurs à ceux des deuxièmes parties (106, 111) et aient des formes et des dimensions sensiblement similaires l'une par rapport à l'autre, et telles que, sur chacune de la face (104) de la première puce électronique (100) et de la première face (108) du substrat (102) ou de la deuxième puce électronique, la première partie (105, 110) soit délimitée par la deuxième partie (106, 111);
- dépôt du premier fluide (112) sur la première partie (110) de la première face (108) du substrat (102) ou de la deuxième puce électronique ;
- dépôt de la première partie (105) de la face (104) de la première puce électronique (100) sur le premier fluide (112) ;
- retrait du premier fluide (112) jusqu'à l'obtention d'une solidarisation de la première partie (105) de la face (104) de la première puce électronique (100) avec la première partie (110) de la première face (108) du substrat (102) ou de la deuxième puce électronique ;
comportant en outre, pendant au moins une partie du retrait du premier fluide (112), une émission d'ultrasons dans le premier fluide (112) à travers le substrat (102) ou la deuxième puce électronique, les ultrasons émis ayant une fréquence supérieure ou égale à environ 1 MHz,
et dans lequel, pendant une première partie du retrait du premier fluide (112), la puissance d'émission des ultrasons est telle que des bulles de cavitation sont formées dans le premier fluide (112), puis, pendant une deuxième partie du retrait du premier fluide (112), la puissance d'émission des ultrasons est réduite afin de stopper la création des bulles de cavitation tout en exerçant une pression mécanique sur la première puce électronique (100).

2. Procédé selon la revendication 1, dans lequel le premierfluide (112) est de l'eau.

3. Procédé selon l'une des revendications précédentes, dans lequel les ultrasons sont émis avec une puissance comprise entre environ 0,1 W/cm² et 5 W/cm².

4. Procédé selon l'une des revendications précédentes, dans lequel la puissance d'émission des ultrasons pendant la première partie du retrait du premier fluide (112) est supérieure ou égale à environ 1 W/cm², et/ou la puissance d'émission des ultrasons pendant la deuxième partie du retrait du premier fluide (112) est réduite jusqu'à une valeur inférieure ou égale à environ 0,2 W/cm².

5. Procédé selon l'une des revendications précédentes, dans lequel les ultrasons sont émis par un émetteur (114) couplé acoustiquement à une deuxième face (116), opposée à la première face (108), du substrat (102) ou de la deuxième puce électronique par l'intermédiaire d'un film d'un deuxième fluide (118).

6. Procédé selon la revendication 5, dans lequel le film du deuxième fluide (118) est un film d'eau.

7. Procédé selon l'une des revendications précédentes, dans lequel la réalisation, sur la face (104) de la première puce électronique (100) et/ou sur la première face (108) du substrat (102) ou de la deuxième puce électronique, des première et deuxième parties (105, 106, 110, 111) comporte la mise en oeuvre d'une étape de gravure de la face (104) de la première puce électronique (100) et/ou de la première face (108) du substrat (102) ou de la deuxième puce électronique autour de premières régions destinées à former les premières parties (105, 110) telle que les premières parties soient formées par des faces supérieures des premières régions et que les deuxièmes parties soient formées au moins par des flancs latéraux des premières régions.

8. Procédé selon la revendication 7, comportant en outre, après l'étape de gravure, une étape de traitement modifiant la valeur de l'angle de contact des flancs latéraux des premières régions et/ou de l'angle de contact de deuxièmes régions entourant les premières régions, vis-à-vis du premier fluide.

9. Procédé selon l'une des revendications précédentes, dans lequel les étapes du procédé sont mises en oeuvre collectivement pour réaliser le collage direct de plusieurs premières puces électroniques (100) sur le substrat (102).

## Patentansprüche

1. Verfahren zum direkten Bonden von mindestens einem ersten elektronischen Chip (100) auf ein Substrat (102) oder auf mindestens einen zweiten elektronischen Chip, umfassend mindestens die Schritte:
- Erzeugen, auf jeder einer Fläche (104) des ersten elektronischen Chips (100) und einer ersten Fläche (108) des Substrats (102) oder des zweiten elektronischen Chips, mindestens eines ersten und eines zweiten Abschnitts (105, 110, 106, 111), die eine Kontaktwinkeldifferenz aufweisen in Bezug auf ein erstes Fluid (112), die größer als etwa 70° zueinander ist, so dass die ersten Abschnitte (105, 110) Kontaktwinkel aufweisen gegenüber dem ersten Fluid (112), die niedriger sind als die der zweiten Abschnitte (106, 111) und Formen und Abmessungen aufweisen, die einander etwa ähnlich sind, und so dass auf jeder der Flächen (104) des ersten elektronischen Chips (100) und der ersten Fläche (108) des Substrats (102) oder des zweiten elektronischen Chips, der erste Abschnitt (105, 110) durch den zweiten Abschnitt (106, 111) begrenzt ist;
- Aufbringen des ersten Fluids (112) auf den ersten Abschnitt (110) der ersten Fläche (108) des Substrats (102) oder des zweiten elektronischen Chips;
- Aufbringen des ersten Abschnitts (105) der Fläche (104) des ersten elektronischen Chips (100) auf das erste Fluid (112);
- Entfernen des ersten Fluids (112) bis eine Verbindung des ersten Abschnitts (105) der Fläche (104) des ersten elektronischen Chips (100) mit dem ersten Abschnitt (110) der ersten Fläche (108) des Substrats (102) oder des zweiten elektronischen Chip erhalten wird;
ferner umfassend, während mindestens eines Abschnitts des Entfernens des ersten Fluids (112), eine Ultraschallemission in dem erste Fluid (112) durch das Substrat (102) oder den zweiten elektronischen Chip, wobei der emittierte Ultraschall eine Frequenz aufweist, die höher oder gleich etwa 1 MHz ist,
und wobei während eines ersten Abschnitts des Entfernens des ersten Fluids (112) die Leistung der Ultraschallemission so ist, dass Kavitationsblasen im ersten Fluid (112) gebildet werden, und dann, während eines zweiten Abschnitts des Entfernens des ersten Fluids (112), die Leistung der Ultraschallemission reduziert wird, um die Bildung von Kavitationsblasen zu stoppen, alles unter Ausüben eines mechanischen Drucks auf den ersten elektronischen Chip (100).

2. Verfahren nach Anspruch 1, wobei das erste Fluid (112) Wasser ist.

3. Verfahren nach einem der vorhergehenden Ansprüche, wobei der Ultraschall mit einer Leistung zwischen etwa 0,1 W/cm² und 5 W/cm² emittiert wird.

4. Verfahren nach einem der vorhergehenden Ansprüche, wobei die Leistung der Ultraschallemission während des ersten Abschnitts des Entfernens des ersten Fluids (112) größer als oder gleich etwa 1 W/cm² ist und/oder die Leistung der Ultraschallemission während des zweiten Abschnitts des Entfernens des ersten Fluids (112) bis auf einen Wert von weniger als oder gleich etwa 0,2 W/cm² verringert wird.

5. Verfahren nach einem der vorhergehenden Ansprüche, wobei der Ultraschall von einem Emitter (114) emittiert wird, der akustisch mit einer zweiten Fläche (116) gegenüber der ersten Fläche (108), des Substrats (102) oder des zweiten elektronischen Chips mittels eines Film eines zweiten Fluids (118) gekoppelt ist.

6. Verfahren nach Anspruch 5, wobei der Film des zweiten Fluids (118) ein Wasserfilm ist.

7. Verfahren nach einem der vorhergehenden Ansprüche, wobei das Erzeugen, auf der Fläche (104) des ersten elektronischen Chips (100) und/oder auf der ersten Fläche (108) des Substrats (102) oder des zweiten elektronischen Chips, der ersten und zweiten Abschnitte (105, 106, 110, 111) das Umsetzen eines Ätzschrittes der Fläche (104) des ersten elektronischen Chips (100) und/oder der ersten Fläche (108) des Substrats (102) oder des zweiten elektronischen Chips, bestimmt für ein Ausbilden der ersten Abschnitte (105, 110), umfasst, so dass die ersten Abschnitte durch obere Flächen der ersten Regionen gebildet werden und die zweiten Abschnitte mindestens durch Seitenflanken der ersten Bereiche gebildet werden.

8. Verfahren nach Anspruch 7, ferner umfassend, nach dem Ätzschritt, einen Behandlungsschritt, der den Wert des Kontaktwinkels der Seitenflanken der ersten Bereiche und/oder des Kontaktwinkel der zweiten Bereiche, umgebend die ersten Bereiche, gegenüber dem ersten Fluid modifiziert.

9. Verfahren nach einem der vorhergehenden Ansprüche, wobei die Schritte des Verfahrens gemeinsam umgesetzt werden, um das direkte Bonden mehrerer erster elektronischer Chips (100) auf dem Substrat (102) zu erreichen.

## Claims

1. A method for directly bonding at least one first electronic chip (100) to a substrate (102) or to at least one second electronic chip, including at least the steps of:
- making, on each of a face (104) of the first electronic chip (100) and a first face (108) of the substrate (102) or of the second electronic chip, at least one first and one second part (105, 110, 106, 111) having a contact angle difference towards a first fluid (112) which is higher than about 70° with respect to each other, such that the first parts (105, 110) have contact angles towards the first fluid (112) lower than those of the second parts (106, 111) and have shapes and dimensions substantially similar with respect to each other, and such that, on each of the face (104) of the first electronic chip (100) and the first face (108) of the substrate (102) or of the second electronic chip, the first part (105, 110) is delimited by the second part (106, 111);
- depositing the first fluid (112) onto the first part (110) of the first face (108) of the substrate (102) or of the second electronic chip;
- depositing the first part (105) of the face (104) of the first electronic chip (100) onto the first fluid (112);
- removing the first fluid (112) until a securement of the first part (105) of the face (104) of the first electronic chip (100) with the first part (110) of the first face (108) of the substrate (102) or of the second electronic chip is achieved;
and further including, during at least part of the removal of the first fluid (112), emitting ultrasound in the first fluid (112) through the substrate (102) or the second electronic chip, the emitted ultrasound having a frequency higher than or equal to about 1 MHz,
and wherein, during a first part of the removal of the first fluid (112), the ultrasound emitting power is such that cavitation bubbles are formed in the first fluid (112), and then, during a second part of the removal of the first fluid (112), the ultrasound emitting power is reduced in order to stop creating cavitation bubbles while exerting a mechanical pressure onto the first electronic chip (100).

2. The method according to claim 1, wherein the first fluid (112) is water.

3. The method according to one of the preceding claims, wherein the ultrasound is emitted with a power between about 0.1 W/cm² and 5 W/cm².

4. The method according to one of the preceding claims, wherein the ultrasound emitting power during the first part of the removal of the first fluid (112) is higher than or equal to about 1 W/cm², and/or the ultrasound emitting power during the second part of the removal of the first fluid (112) is reduced to a value lower than or equal to about 0.2 W/cm².

5. The method according to one of the preceding claims, wherein the ultrasound is emitted by an emitter (114) acoustically coupled to a second face (116), opposite to the first face (108), of the substrate (102) or of the second electronic chip through a film of a second fluid (118).

6. The method according to claim 5, wherein the film of the second fluid (118) is a water film.

7. The method according to one of the preceding claims, wherein making, on the face (104) of the first electronic chip (100) and/or on the first face (108) of the substrate (102) or of the second electronic chip, the first and second parts (105, 106, 110, 111) includes implementing a step of etching the face (104) of the first electronic chip (100) and/or the first face (108) of the substrate (102) or of the second electronic chip around first regions intended to form the first parts (105, 110) such that the first parts are formed by upper faces of the first regions and that the second parts are formed at least by side flanks of the first regions.

8. The method according to claim 7, further including, after the etching step, a treating step modifying the contact angle value of the side flanks of the first regions and/or the contact angle of the second regions surrounding the first regions, towards the first fluid.

9. The method according to one of the preceding claims, wherein the steps of the method are collectively implemented for making direct bonding of several first electronic chips (100) to the substrate (102).
